# EUROPEAN PATENT SPECIFICATION

(11) **EP 0 425 137 B1**
(45) Date of publication and mention of the grant of the patent: **15.09.1993**
(21) Application number: 90311156.5
(22) Date of filing: 11.10.1990
(51) Int. Cl.: B23K 26/18, B23K 26/00

(54) **Apparatus and method for the production of grooves or ribs in or on a surface**
Vorrichtung und Verfahren für die Produktion von Nuten oder Rippen in oder auf einer Oberfläche
Dispositif et méthode pour la production de rainures ou de nervures dans ou sur une surfaçe

(30) Priority: 21.10.1989 GB 8923766
(43) Date of publication of application: 02.05.1991
(73) Proprietor: BRITISH AEROSPACE PUBLIC LIMITED COMPANY, Farnborough, Hants. GU14 6YU (GB)
(72) Inventor: Lloyd, Mark Llewellyn, Sowerby Research Centre, Filton, Bristiol BS12 7QW (GB)
(74) Representative: Rooney, Paul Blaise

(56) References cited:
- DE-A- 2 001 535
- PATENT ABSTRACTS OF JAPAN vol. 7, no. 85 (M-206)(1230) 09 April 1983,& JP-A-58 9782 (KOGYO GIJUTSUIN) 20 January 1983,

## Description

This invention relates to apparatus and a method for the production of grooves or ribs in or on a surface using a mask and is particularly, but not exclusively, concerned with such an apparatus and method for the production of grooves in a surface by laser.

Grooves may be formed in a substantially planar surface, either in a paint layer on a metal substrate or in an unpainted metal surface by subjecting the surface to a directed beam of laser energy emission. The laser beam impinges on the surface at right angles thereto and the surface and beam are moved relative to one another so that the beam removes material from the surface along a path which is generally groove shaped. One of the problems of this technique is the difficulty of controlling the shape of the grove over its cross section, that is its profile.

Control of the form of the groove over its cross section may be improved by using a mask provided with a series of side by side slot-like apertures therein each conforming to the shape in plan desired for a groove to be produced. Such a mask is located between the laser beam source, which may include a beam focusing lens and the surface. The mask conveniently is fixed relative to the beam source and lens so that if the beam source and lens are moveable relative to the surface, the mask moves with the beam source and lens. However it is difficult to make such a mask which will enable grooves (or ribs) to be produced laterally close to one another due to the difficulty of forming slots laterally close to one another in the mask and the difficulty of such a mask being too fragile for use.

There is thus a need for a generally improved apparatus and method for the production of grooves or ribs in or on a surface.

According to a first aspect of the present invention there is provided an apparatus for the production of grooves or ribs in or on a surface, comprising a mask made of sheet material and provided with at least two rows of parallel sided apertures therethrough, with the apertures of the first of said two rows being in laterally spaced apart side by side parallel relationship and with the apertures of second of said two rows being in laterally spaced apart side by side parallel relationship and being in staggered relationship to the apertures of the first row, so that each second row aperture extends close to the ends of two adjacent first row apertures in extension of the spacing between said two adjacent first row apertures leaving a reinforcing web of sheet material between adjoining first and second row apertures; a source of material deposition for rib production or a source of material removal for groove production and means for causing relative motion between the mask and said surface.

Preferably the apertures in the mask are square or rectangular in shape, or have rounded or pointed ends.

According to a further aspect of the present invention there is provided a method for the production of grooves or ribs in or on a surface, including the steps of positioning the surface face to face with a mask, with or without a space therebetween, which mask is made of sheet material and is provided with at least two rows of parallel sided apertures therethrough, with the apertures of the first of said two rows being in laterally spaced apart side by side parallel relationship and with the apertures of second of said two rows being in laterally space apart side by side parallel relationship and being in staggered relationship to the apertures of the first row, so that each second row aperture extends close to the ends of two adjacent first row apertures and in extension of the spacing between said two adjacent first row apertures leaving a reinforcing web of sheet material between adjoining first and second row apertures, applying a source of material deposition for rib production or a source of material removal for groove production to the side of the mask remote from said surface to deposit material on or remove material from said surface through said apertures and causing relative motion between the surface on the one hand and the mask on the other hand in a direction parallel to the direction of the aperture sides so that the height of said rib material deposition on the surface or the depth of said groove material removed from said surface is proportional to the length of each said aperture and the speed of relative movement between it and said surface.

For a better understanding of the present invention, and to show how the same may be carried into effect, reference will now be made, by way of example, to the accompanying single figure drawing which shows diagrammatically in plan view a mask for use with the apparatus and method of the present invention for the production of grooves or ribs in or on a surface.

A mask suitable for use with the present invention is suitable for the production of grooves or ribs in or on a surface. Although the mask could be used for formation of ribs by deposition of material such as metal, paint or plastics, in any convenient manner such as by sputtering or spraying, the use will be described specifically for the production of a groove in a substrate for convenience.

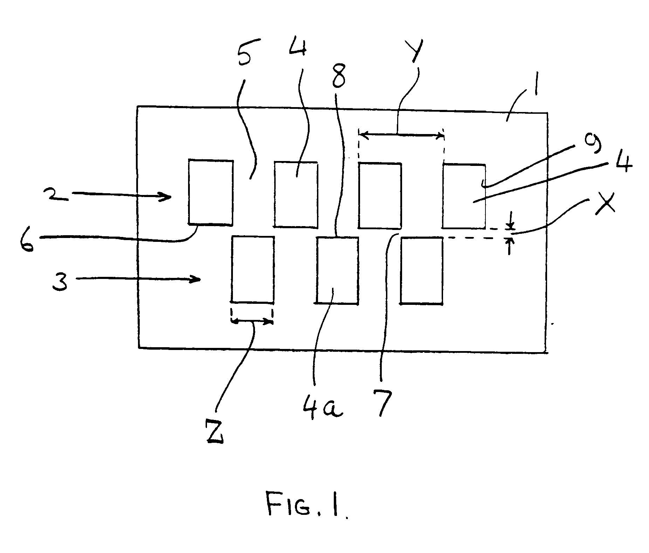

As shown in the accompanying single figure drawing Figure 1 a mask 1 is made of sheet material such as metal or plastics and is provided with at least two rows 2 and 3 of parallel sided apertures 4 and 4a therethrough. The apertures 4 of the first row 2 are in laterally spaced apart side by side parallel relationship leaving a web 5 between each aperture 4. The apertures 4a of the second row 3 are in laterally spaced apart side by side parallel relationship and are in staggered relationship to the apertures 4 of the first row 2. In this way each second row aperture 4a extends close to the ends 6 of two adjacent first row apertures 4 and in extension to the spacing web 5 between the two adjacent first row apertures 4 leaving a reinforcing web 7 of sheet material between adjoining first and second row apertures 4 and 4a.

Such a form of construction enables the mask 1 to be used for the formation of a series of closely laterally spaced grooves as will be hereinafter described without making the mask itself fragile. For example the dimension X of the reinforcing rib 7 between the end 6 of the apertures 4 and the end 8 of the apertures 4a may be selected to impart any desired degree of rigidity to the mask 1. Similarly the width of the spacing web 5 between the apertures 4 may be made larger than the width of the apertures 4a so that the grooves when produced are very close to one another, or even smaller than the width of the apertures 4a so that the grooves produced are wider spaced apart. The staggered arrangement of the rows 2 and 3 enables this to be done without weakening the mask 1 whereas if this were done by using a single row of apertures located as close as possible laterally to one another such a mask would be unduly weak. Similarly by means of the reinforcing web 7 between the rows 2 and 3 the use of apertures 4a close in width to the width of the spacing web 5 between the apertures 4 does not weaken unduly the mask 1.

The distance Y represents twice the pitch of the grooves produced and the distance Z represents the width of the grooves produced. Z may be larger or smaller than Y/2.

In the illustrated mask the apertures 4 and 4a are rectangular in shape but they could alternatively be square in shape with the ends 6 and 8 thereof rounded or pointed in plan. Although in the illustrated mask the apertures of each row 2 and 3 are of the same length the apertures of one row could be different in length from the apertures of the other row and indeed the apertures in each row could be of different length.

Grooves may be produced in a surface, such as in a paint surface on a metal substrate by positioning the mask 1 and the surface face to face, with or without a spacing therebetween, and the application of a source of material removal (or a source of material deposition for rib production) to the side of the mask 1 remote from the surface to remove material from the surface of deposit material thereon, through the apertures 4 and 4a. To do this means are operated to cause relative motion between the surface on the one hand and the mask 1 on the other hand in a direction parallel to the direction of the aperture sides 9 so that the depth of groove material removed from the surface (or the height of rib material deposited on the surface) is proportional to the length of each aperture 4, 4a and the speed of relative movement between it and the surface.

Preferably the source of material removal is a laser and the surface is paint on a metal or plastic substrate. The mask 1 should be fixed relative to the source of the laser beam energy emission and any focusing lens thereof so that the mask and lens beam form one unit moveable relative to the surface.

Although the mask 1 may be aligned parallel to the surface it may alternatively be tilted relative to the surface either in the direction of relative movement between the mask and surface or transverse thereto for fine tuning or adjustment purposes. Alternatively the mask 1 may be rotated or skewed about an axis extending substantially perpendicularly to the surface. This enables the shape of the flanks on the sides of the grooves to be controlled, for example rounded.

## Claims

1. An apparatus for the production of grooves or ribs in or on a surface, comprising a mask (1) made of sheet material and provided with at least two rows (2,3) of parallel sided apertures (4,4a) therethrough, with the apertures (4) of the first (2) of said two rows being in laterally spaced apart side by side parallel relationship and with the apertures (4a) of second of (3) said two rows being in laterally spaced apart side by side parallel relationship and being in staggered relationship to the apertures (4) of the first row (2), so that each second row aperture (4a) extends close to the ends (6) of two adjacent first row apertures (4) and in extension of the spacing (5) between said two adjacent first row apertures (4) leaving a reinforcing web (7) of sheet material between adjoining first and second row apertures (4,4a); a source of material deposition for rib production or a source of material removal for groove productions, and means for causing relative motion between the mask (1) and said surface.

2. Apparatus according to Claim 1, wherein the apertures (4,4a) in the mask (1) are square or rectangular in shape.

3. Apparatus according to Claim 1, wherein the apertures (4,4a) in the mask (1) have rounded or pointed ends (6,8).

4. A method for the production of grooves or ribs in or on a surface, including the steps of positioning the surface face to face with a mask (1), with or without a space therebetween, which mask (1) is made of sheet material and is provided with at least two rows (2,3) of parallel sided apertures (4,4a) therethrough, with the apertures (4) of the first (2) of said two rows being in laterally spaced apart side by side parallel relationship and with the apertures (4a) of second of (3) said two rows being in laterally space apart side by side parallel relationship and being in staggered relationship to the apertures (4) of the first row (2), so that each second row aperture (4a) extends close to the ends (6) of two adjacent first row apertures (4) and in extension of the spacing (5) between said two adjacent first row apertures (4) leaving a reinforcing web (7) of sheet material between adjoining first and second row apertures (4,4a), applying a source of material deposition for rib production or a source of material removal for groove production to the side of the mask (1) remote from said surface to deposit material on or remove material from said surface through said apertures (4,4a) and causing relative motion between the surface on the one hand and the mask (1) on the other hand in a direction parallel to the direction of the aperture sides (9) so that the height of said rib material deposition on the surface or the depth of said groove material removed from said surface is proportional to the length of each said aperture (4,4a) and the speed of relative movement between it and said surface.

5. A method according to claim 4, wherein the source of material deposition is a spray of molten metal, plastics or paint and wherein the surface is metal and/or plastics.

6. A method according to Claim 4, wherein the source of material removal is a laser and wherein the surface is paint, metal or plastics.

7. A method according to any one of claims 4 to 6, in which the mask (1) is parallel to the surface during material deposition or material removal.

8. A method according to any one of Claims 4 to 6, in which the mask (1) is tilted with respect to the surface, the tilt being either in the direction of relative movement between the mask (1) and surface or transverse thereto, for adjustment purposes.

9. A method according to any one of Claims 4 to 6, in which the mask (1) is skewed or rotated about an axis extending substantially perpendicularly to the surface to produce rounded shoulders on the ribs or rounded flanks on the grooves.

## Patentansprüche

1. Vorrichtung zur Herstellung von Nuten oder Rippen in oder auf einer Oberfläche, mit einer Maske (1) aus Blattmaterial, die mit wenigstens zwei Reihen (2, 3) von parallelseitigen durchgehenden Öffnungen (4, 4a) versehen sind, wobei die Öffnungen (4) der ersten (2) der beiden Reihen seitlich im Abstand und seitlich nebeneinander parallel zueinander angeordnet sind und die Öffnungen (4a) der zweiten Reihe (3) der beiden Reihen seitlich im Abstand zueinander und parallel zueinander gestaffelt zu den Öffnungen (4) der ersten Reihe (2) angeordnet sind, so daß jede Öffnung (4a) der zweiten Reihe sich dicht zu den Enden (6) der beiden benachbarten Öffnungen (4) der ersten Reihe erstreckt und in Erstreckung des Abstandes (5) zwischen den zwei benachbarten Öffnungen (4) der ersten Reihe einen Verstärkungssteg (7) aus Blattmaterial zwischen benachbarten Öffnungen (4, 4a) von erster und zweiter Reihe beläßt, und wobei eine Quelle zur Materialablagerung zur Erzeugung von Rippen oder eine Quelle zum Abnehmen von Material zur Nutherstellung und Mittel vorgesehen sind, die eine Relativbewegung zwischen der Maske (1) und der Oberfläche bewirken.

2. Vorrichtung nach Anspruch 1, bei welcher die Öffnungen (4, 4a) in der Maske (1) eine quadratische oder rechteckige Gestalt aufweisen.

3. Vorrichtung nach Anspruch 1, bei welcher die Öffnungen (4, 4a) in der Maske (1) abgerundete oder angespitzte Enden (6, 8) aufweisen.

4. Verfahren zur Erzeugung von Nuten oder Rippen in oder auf einer Oberfläche, mit den folgenden Schritten: es wird auf die Oberfläche mit oder ohne Abstand eine Maske (1) gelegt, welche Maske (1) aus Blattmaterial besteht und mit wenigstens zwei Reihen (2, 3) parallelseitiger durchgehender Öffnungen (4, 4a) versehen ist, wobei die Öffnungen (4) der ersten (2) der zwei Reihen seitlich im Abstand und seitlich parallel zu den Öffnungen (4a) der zweiten (3) der beiden Reihen verlaufen, mit seitlichem Abstand und parallelseitig und in Staffelung zu den Öffnungen (4) der ersten Reihe (2), so daß jede Öffnung (4a) der zweiten Reihe sich dicht benachbart zu den Enden (6) von zwei benachbarten Öffnungen (4) der ersten Reihe erstreckt, und in Erstreckung des Abstandes (5) zwischen den beiden benachbarten Öffnungen (4) der ersten Reihe ein Verstärkungssteg (7) aus Blattmaterial zwischen benachbarten Öffnungen (4, 4a) der ersten und zweiten Reihe verbleibt; es wird eine Quelle zur Materialablagerung für die Rippenerzeugung oder eine Quelle zum Materialabtragen zur Nutherstellung auf jener Seite der Maske (1) angebracht, die der Oberfläche gegenüberliegt, auf der Material durch die Öffnungen (4, 4a) abgelagert oder entfernt wird, und es wird eine Relativbewegung zwischen der Oberfläche einerseits und der Maske (1) andererseits in einer Richtung parallel zur Richtung der Seitenränder (9) der Öffnung derart durchgeführt, daß die Höhe der Rippenmaterialablagerung auf der Oberfläche oder die Tiefe des aus der Nut entfernten Materials proportional zur Länge einer jeden Öffnung (4, 4a) ist und zur Geschwindigkeit der Relativbewegung zwischen der Maske und der Oberfläche.

5. Verfahren nach Anspruch 4, bei welchem die Quelle der Materialablagerung eine Sprühvorrichtung für geschmolzenes Metall, Plastik oder Farbe ist und die Oberfläche metallisch ist und/oder aus Plastik besteht.

6. Verfahren nach Anspruch 4, bei welchem die Quelle zur Materialabtragung ein Laser ist und die Oberfläche eine Farbe, ein Metall oder Plastikmaterial ist.

7. Verfahren nach einem der Ansprüche 4 bis 6, bei welchem die Maske (1) parallel zur Oberfläche liegt, während die Materialablagerung oder Materialabnahme erfolgt.

8. Verfahren nach einem der Ansprüche 4 bis 6, bei welchem die Maske (1) gegenüber der Oberfläche geneigt wird und die Neigung entweder in Richtung der Relativbewegung zwischen der Maske (1) und der Oberfläche erfolgt oder quer hierzu, um Einstellungen vorzunehmen.

9. Verfahren nach einem der Ansprüche 4 bis 6, bei welchem die Maske (1) um eine Achse schräggestellt oder gedreht wird, die im wesentlichen senkrecht zur Oberfläche verläuft, um abgerundete Schultern auf den Rippen oder abgerundete Flanken an den Nuten zu erzeugen.

## Revendications

1. Appareil pour la fabrication de rainures ou de nervures dans ou sur une surface, comportant un masque (1) réalisé dans une matière en feuille et pourvu d'au moins deux rangées (2, 3) d'ouvertures à côtés parallèles (4, 4a), avec les ouvertures (4) de la première (2) des deux rangées qui sont en relation parallèle côte-à-côte latéralement espacée et avec les ouvertures (4a) de la deuxième (3) desdites rangées qui sont en relation parallèle côte-à-côte latéralement espacée et qui sont en relation décalée par rapport aux ouvertures (4) de la première rangée (2), de telle sorte que chaque ouverture de deuxième rangée (4a) s'étend à proximité des extrémités (6) de deux ouvertures de première rangée adjacentes (4) et dans le prolongement de l'espace (5) entre lesdites deux ouvertures de première rangée adjacentes (4) en laissant une bande de renforcement (7) de matière en feuille entre des ouvertures de première et deuxième rangées adjacentes (4, 4a); une source de dépôt de matière pour la fabrication de nervures ou une source d'enlèvement de matière pour la fabrication de rainures, et des moyens destinés à entraîner un déplacement relatif entre le masque (1) et ladite surface.

2. Appareil selon la revendication 1, dans lequel les ouvertures (4, 4a) dans le masque (1) sont de forme carré ou rectangulaire.

3. Appareil selon la revendication 1, dans lequel les ouvertures (4, 4a) dans le masque (1) ont des extrémités arrondies ou pointues (6, 8).

4. Procédé de fabrication de rainures ou de nervures dans ou sur une surface, comprenant les étapes de positionnement de la surface face à un masque (1), avec ou sans espace entre eux, lequel masque (1) est réalisé dans une matière en feuille et est pourvu d'au moins deux rangées (2, 3) d'ouvertures à côtés parallèles (4, 4a), avec les ouvertures (4) de la première (2) des deux rangées qui sont en relation parallèle côte-à-côte latéralement espacée et avec les ouvertures (4a) de la deuxième (3) desdites deux rangées qui sont en relation parallèle côte-à-côte latéralement espacée et qui sont en relation décalée par rapport aux ouvertures (4) de la première rangée (2), de telle sorte que chaque ouverture de deuxième rangée (4a) s'étend à proximité des extrémités (6) de deux ouvertures de première rangée adjacentes (4) et dans le prolongement de l'espace (5) entre lesdites deux ouvertures de première rangée adjacentes (4) en laissant une bande de renforcement (7) de matière en feuille entre des ouvertures de première et deuxième rangées adjacentes (4, 4a), d'application d'une source de dépôt de matière pour la fabrication de nervures ou d'une source d'enlèvement de matière pour la fabrication de rainures sur le côté du masque (1) éloigné de ladite surface afin de déposer de la matière sur ou d'enlever de la matière dans ladite surface à travers lesdites ouvertures (4, 4a) et de déplacement relatif entre la surface d'une part et le masque (1) d'autre part dans une direction parallèle à la direction des côtés d'ouverture (9) de telle sorte que la hauteur dudit dépôt de matière de nervure sur la surface ou la profondeur de ladite matière de rainure enlevée de ladite surface est proportionnelle à la longueur de chaque ouverture (4, 4a) et à la vitesse du déplacement relatif entre celle-ci et ladite surface.

5. Procédé selon la revendication 4, dans lequel la source de dépôt de matière est une pulvérisation de métal fondu, de matière plastique ou de peinture et dans lequel la surface est en métal et/ou en matière plastique.

6. Procédé selon la revendication 4, dans lequel la source d'enlèvement de matière est un laser et dans lequel la surface est de la peinture, du métal ou de la matière plastique.

7. Procédé selon l'une quelconque des revendications 4 à 6, dans lequel le masque (1) est parallèle à la surface pendant le dépôt de matière ou l'enlèvement de matière.

8. Procédé selon l'une quelconque des revendications 4 à 6, dans lequel le masque (1) est incliné par rapport à la surface, l'inclinaison étant dans la direction de déplacement relatif entre le masque (1) et la surface, ou bien transversale à celui-ci, à des fins de réglage.

9. Procédé selon l'une quelconque des revendications 4 à 6, dans lequel le masque (1) est décalé ou tourné autour d'un axe s'étendant sensiblement perpendiculairement à la surface afin de produire des épaulements arrondis sur les nervures ou des flancs arrondis sur les rainures.
